# FASCICULE DE BREVET EUROPEEN

(11) **EP 1 192 591 B1**
(45) Date de publication et mention de la délivrance du brevet: **16.04.2003**
(21) Numéro de dépôt: 00936989.3
(22) Date de dépôt: 30.05.2000
(51) Int. Cl.: G06K 19/077

(54) **PROCEDE POUR LA FABRICATION D'UN MODULE POUR CARTES A PUCES**
VERFAHREN ZUR HERSTELLUNG EINES MODULS FÜR CHIPKARTEN
METHOD FOR MAKING A MODULE FOR CHIP CARDS

(30) Priorité: 17.06.1999 FR 9908123
(43) Date de publication de la demande: 03.04.2002
(73) Titulaire: Gemplus, 13881 Gémenos Cedex (FR)
(72) Inventeur: FIDALGO, Jean-Christophe, F-13420 Gémenos (FR); DOSSETTO, Lucille, F-13600 La Ciotat (FR)
(86) Numéro de dépôt international: FR0001491
(87) Numéro de publication internationale: WO00079478

(56) Documents cités:
- EP-A- 0 688 050
- EP-A- 0 774 779
- US-A- 5 850 690

## Description

L'invention concerne la fabrication de cartes à puce à contacts affleurants et/ou sans contact.

Ces cartes à puce servent par exemple à des opérations bancaires, de gestion des communications téléphoniques ou d'identification.

Les cartes à contacts comportent des métallisations, formant plages de contact, qui affleurent à la surface de la carte. Ces métallisations sont disposées à un endroit du corps de carte, défini par la norme ISO 7816.

De manière générale, une grille de métallisation est constituée par les plages de contacts et éventuellement les pistes conductrices dans les cartes à contacts affleurants, et par l'antenne dans le cas d'une carte à puce sans contact.

Dans tous les cas, la métallisation requiert le plus grand soin et est l'une des étapes de fabrication des modules de circuit imprimé entrant pour une part importante dans le coût global de ces modules.

La qualité de la réalisation de cette métallisation conditionne également fortement le taux de rebuts lors des contrôles de qualité.

Pour simplifier, il sera fait référence dans la suite uniquement aux cartes à puce à contacts affleurants.

Parmi les procédés. connus pour la fabrication de cartes à puce, les principaux sont des procédés fondés sur l'assemblage de la puce dans un sous-ensemble appelé micromodule.

Dans les documents FR2671416, FR2671417 et FR2671418, la fabrication de cartes à puce sans étape intermédiaire de réalisation d'un micromodule, comprend l'encartage d'une puce de circuit intégré directement dans un corps de carte. Ces techniques reposent sur une étape de ramollissement local d'un corps de carte en matière plastique et le pressage de la puce dans la zone ainsi ramollie. La puce est alors disposée de telle sorte que ses plots de contact affleurent à la surface de la carte.

Le document EP-A-774 779 décrit la fabrication d'un micromodule. Les plages metalliques sont formées sur une grille support avec des barrières de protection de manière à former un contour fermé.

Le document EP-A-0 688 050 décrit des étapes de report et de fixation d'un circuit intégré dans une cavité de corps de carte.

Une autre solution proposée pour réduire le prix de revient des cartes à puce utilise la technologie dite "Chrysalide", qui repose sur l'application de pistes électriquement conductrices par un procédé de type MID ("Moulded Interconnection Device" dans la littérature anglo-saxonne). Selon divers procédés faisant appel à cette technologie, décrits par exemple dans les documents EP-A-0 753 827, EP-A-0 688 050 et EP-A-0 688 051, la carte est munie d'un logement destiné à recevoir le circuit intégré. Des pistes électriquement conductrices sont disposées contre le fond et les parois latérales de ces logements et sont- reliées à des plages métalliques de contact formées sur la surface du support de carte.

L'application des pistes conductrices dans ledit logement peut être effectuée de trois manières différentes:
- Une première manière consiste à réaliser un estampage à chaud. Une feuille comportant des métallisations en cuivre, éventuellement recouvertes d'étain ou de nickel, et munie d'une colle activable à chaud, est découpée, puis collée à chaud dans ledit logement.
- Une deuxième manière consiste à appliquer, au moyen d'un tampon, une laque contenant un catalyseur au palladium, aux endroits destinés à être métallisés, et à chauffer la laque. La métallisation est réalisée ensuite par dépôt de cuivre et/ou de nickel, au moyen d'un procédé électrochimique d'autocatalyse.
- Une troisième manière consiste à réaliser une lithogravure à partir d'hologrammes au laser. Cette lithogravure permet de réaliser des dépôts de métallisation en trois dimensions. avec une très grande précision et une haute résolution.

Selon ces techniques, c'est le corps de carte proprement dit qui doit être métallisé, avant son impression finale, ce qui augmente d'autant le coût des rebuts d'impression. De plus, il est dans ce cas nécessaire de reporter la puce directement dans le corps de carte, ce qui exige un équipement de report à plus faible cadence que ceux utilisés pour un report sur bande. Le prix de revient des cartes ainsi fabriquées reste donc élevé, tandis que le taux de rebut est également maintenu à un niveau élevé.

En vue d'une production industrielle à grande échelle et à moindre coût, la présente invention propose un procédé de fabrication telle que définie dans les revendications.

D'autres particularités et avantages de la présente invention apparaîtront à la lumière de la description qui suit, donnée à titre d'exemple illustratif et non limitatif, et faite en référence aux figures annexées, qui représentent:

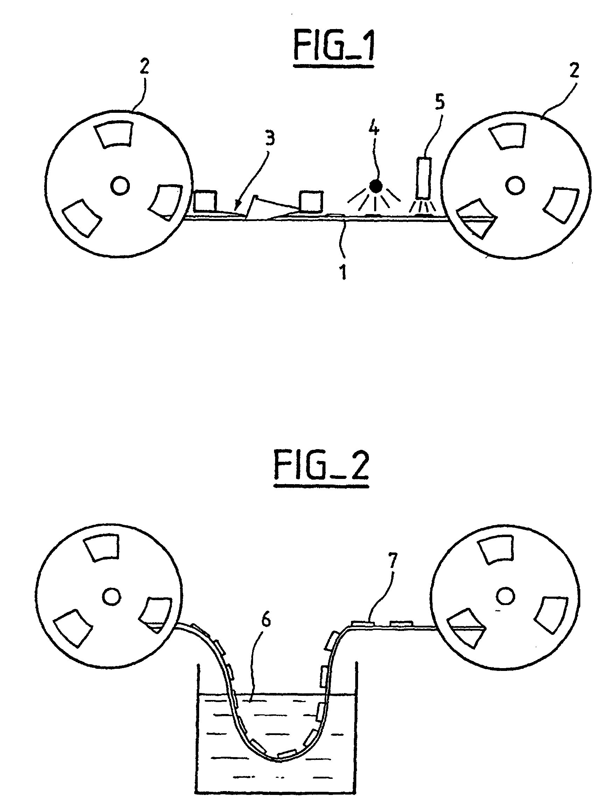

- Fig. 1 une vue en coupe transversale schématique d'une métallisation sur bande de film support diélectrique par le procédé selon l'invention.
- Fig. 2 une vue en coupe transversale schématique du dépôt non électrolytique subséquent par passage dans un bain d'un sel métallique.

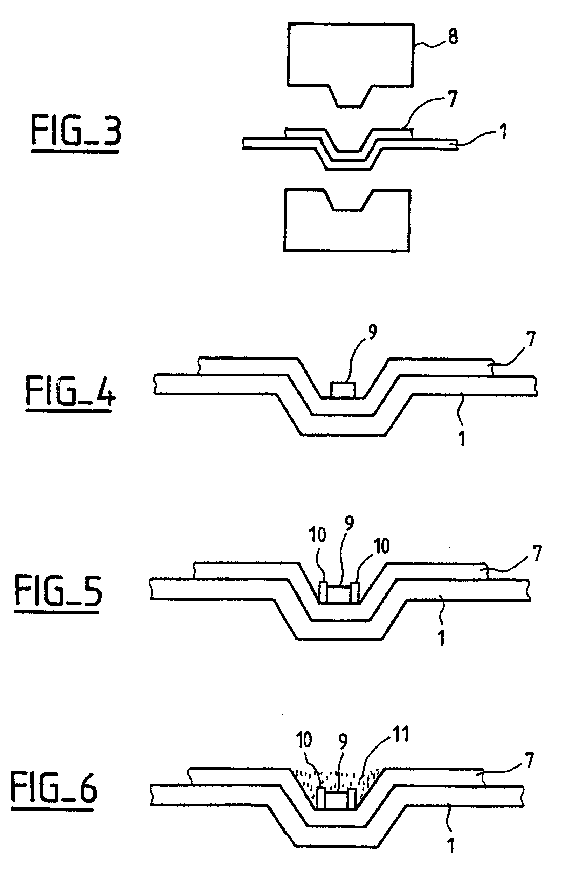

- Fig. 3 une vue en coupe transversale schématique d'un thermoformage d'un micromodule isolé de la bande provenant de l'étape précédente, selon la figure 2,
- Fig. 4 une vue en coupe transversale schématique après collage d'une puce sur le support préalablement thermoformé comme représenté sur la figure 3,
- Fig. 5 une vue en coupe transversale schématique après câblage entre la puce et les pistes du substrat provenant de l'opération de collage selon la figure 4,
- Fig. 6 une vue en coupe transversale schématique du micromodule selon la figure 5, après un enrobage de la puce et des connexions, utilisant le volume de la cavité préalablement formée.

Dans une première étape, on fait défiler une bande 1 de film support diélectrique pour micromodules de carte à puce entre des bobines 2 en regard d'un dispositif de sérigraphie 3, puis avantageusement sous un dispositif d'insolation 4 et un dispositif de séchage à chaud 5.

Dans une deuxième étape, on fait passer la bande 1 dans un bain 6 de métallisation selon l'invention, tel que par exemple pour une métallisation non électrolytique telle que décrite plus haut, pour former sur la bande 1 des zones métallisées destinées à former des grilles de métallisation 7 pour carte à puce à contacts affleurants et/ou sans contact.

Ensuite on crée une cavité par thermoformage, à une température supérieure à la température de transition vitreuse du substrat de la bande 1, dans un appareillage de thermoformage classique 8, soit sur une unité pour micromodule, soit de préférence sur le substrat 1 en rouleau sur les bobines 2, éventuellement en ligne.

Une puce 9 est ensuite collée dans le fond de la cavité ainsi formée.

Par un câblage au moyen de fils de connexion 10 entre les plots de la puce 9 et la grille de métallisation 7 portée par la bande 1 on assure la connexion de la puce 9 avec ladite grille 7.

La fabrication du micromodule pour carte à puce comprend encore l'enrobage de la puce 9 et des connexions dans une résine 11 appropriée, à l'intérieur du volume de la cavité susmentionnée.

En option, on peut intercaler entre le passage dans le bain de métallisation 6 et le thermoformage avec le dispositif 8 une étape de dépôt électrolytique de métal (non représentée), qui accroît l'épaisseur de métal déposée sur la bande 1 pour former la grille de métallisation.

La technique de photolithographie, non représentée, fait intervenir des moyens dont l'homme du métier de la technique concernée est familier. Leur principe a été rappelé plus haut et ils n'ont donc pas à être détaillés ici.

Dans une variante de réalisation du procédé de fabrication d'un support de mémorisation de type carte à puce complet, le micromodule, ou le substrat correspondant à la partie du film support diélectrique supportant le motif sans la puce, est inséré dans le corps du support de mémorisation au cours de l'injection de celui-ci. Pour ce faire, le substrat est séparé du reste de la bande et découpé aux dimensions finales du micromodule. Ce substrat, avec ou sans puce selon le cas, est ensuite bridé dans le moule d'injection, afin d'y être maintenu en position durant l'injection du matériau de constitution du corps de carte, et de conférer l'étanchéité requise pour que la matière injectée ne passe pas entre le module et le moule et ne recouvre pas la grille susdite. Dans la pratique, ce bridage peut être effectué par une aspiration ou encore par un procédé électrostatique. La matière de constitution du corps de carte est ensuite injectée dans le moule.

Dans le cas où l'injection est réalisée dans un moule à noyau fixe, le substrat prend la forme du moule sous la pression de la matière injectée.

Dans le cas où l'injection est réalisée dans un moule à noyau mobile, on effectue dans un premier temps l'injection de la matière et on réalise dans un deuxième temps la déformation du substrat en mettant en place le noyau aux dimensions de la cavité juste après l'injection.

A la fin de cette opération d'injection, on obtient une carte munie d'un module formé aux reliefs de la cavité désirée, avec des contacts électriques affleurants.

Le support de mémorisation selon l'invention comporte ainsi une grille de métallisation tridimensionnelle.

Dans une variante de réalisation, le substrat du micromodule peut en outre comporter des perforations pratiquées dans son épaisseur. Ces perforations visent à permettre à la résine d'encapsulation d'entrer en contact direct avec le matériau du corps de carte, et de constituer ainsi un point d'ancrage du module dans la cavité. De plus, elles permettent d'évacuer d'éventuelles bulles d'air qui peuvent se trouver emprisonnées entre la cavité du corps de carte et le substrat.

## Revendications

1. Procédé de fabrication d'un support de mémorisation de type carte à puce à contacts affleurants et/ou sans contact, comprenant un micromodule comportant un film support (1) portant une grille de métallisation (7), et une puce de circuit intégré (9) placée dans une zone de report et reliée à ladite grille de métallisation (7), ledit procédé étant **caractérisé en ce qu'**il comporte les étapes, en ordre quelconque, consistant à:
- réaliser une grille de métallisation (7) sur le film support (1) du micromodule, et
- déformer le film support (1) de manière qu'au moins ladite zone de report soit à un niveau inférieur par rapport au plan de ladite grille de métallisation.

2. Procédé selon la revendication 1, **caractérisé en ce qu'**il comporte en outre les étapes ultérieures de confection des cartes à puce sur bobine et/ou en ligne.

3. Procédé selon la revendication 1, **caractérisé en ce qu'**on réalise la grille de métallisation par un procédé non électrolytique.

4. Procédé selon la revendication 3, **caractérisé en ce qu'**il comporte le dépôt d'un initiateur de grille de métallisation par une méthode additive, sous la forme d'un dépôt d'au moins une amorce de métallisation selon des motifs prédéfinis correspondant aux surfaces de ladite grille de métallisation, par sérigraphie, tampographie, offset, jet d'encre, flexographie, agent traceur ou toute technique analogue, puis la fixation non électrolytique d'au moins un métal approprié, tel que par exemple Cu, Ni et/ou Au, catalysée par ladite amorce sur les zones où elle est présente.

5. Procédé selon la revendication 4, **caractérisé en ce que** l'amorce de métallisation est choisie parmi les matières catalytiques à base de palladium utilisées pour la métallisation des substrats polymères.

6. Procédé selon la revendication 4, **caractérisé en ce que** l'amorce de métallisation consiste essentiellement en un agent filmogène tel que du polyuréthanne, un additif conférant une tensio-activité appropriée, tel qu'un polyester, un polyamide et/ou une polyoxazolidone, un métal noble ionique et/ou colloïdal, ou un composé covalent ou complexe de celui-ci avec des ligands organiques, en particulier un complexe ou un sel inorganique de Cu, Au, Ag, Pt, Pd ou Ru, des charges organiques et/ou inorganiques et un solvant organique.

7. Procédé selon la revendication 4, **caractérisé en ce qu'**il comporte une activation de ladite amorce, notamment par insolation sous rayonnement UV, ainsi qu'un séchage.

8. Procédé selon la revendication 4, **caractérisé en ce qu'**il comprend l'imprégnation du support ayant une forme d'une bande directement ou ultérieurement dans un bain (6) d'un sel du métal choisi pour la métallisation, par exemple Cu, Ni et/ou Au, en continu, séquentiellement ou en discontinu.

9. Procédé selon la revendication 4, **caractérisé en ce qu'**il comporte en outre une étape subséquente de dépôt électrolytique d'une couche supplémentaire de métal, tel que par exemple Cu, Ni, Au ou Pd, sur les mêmes zones (7) du film support que celles ayant reçu la métallisation susdite.

10. Procédé selon la revendication 3, **caractérisé en ce qu'**il comporte le dépôt non électrolytique d'au moins un métal approprié, tel que par exemple Cu, et la réalisation de la métallisation selon des motifs prédéfinis, par une méthode soustractive selon une image correspondant à ladite grille de métallisation, en particulier par photolithographie.

11. Procédé selon la revendication 3, **caractérisé en ce qu'**on applique d'abord sur le substrat polymère à traiter, constitué par le film support diélectrique susdit, une couche fine d'au moins un métal tel que Cu, Ni ou Au, de préférence par une technique de dépôt sous vide.

12. Procédé selon l'une des revendications 1 ou 2, **caractérisé en ce qu'**on lamine une grille métallique découpée mécaniquement sur le film support.

13. Procédé selon la revendication 10, **caractérisé en ce que** la photolithographie proprement dite comporte les étapes de:
- dépôt d'une couche de résine photosensible sur le métal susdit,
- insolation à travers un masque ou un film,
- développement de la résine,
- gravure du métal dans les zones non protégées par la résine, et
- enlèvement de la résine photosensible.

14. Procédé selon la revendication 10, **caractérisé en ce qu'**on procède en outre soit avant, soit après la mise en oeuvre de la photolithographie, à un dépôt électrolytique d'un revêtement métallique, notamment un revêtement de Ni+Au, Ni+Pd et/ou Ni+Pd+flash Au, où "flash Au" désigne un dépôt de faible épaisseur du métal Au.

15. Procédé selon l'une quelconque des revendications 1 à 14, **caractérisé en ce qu'**il comprend en outre les étapes suivantes, consistant à: fixer et connecter la puce avant la déformation du film support diélectrique, puis déformer le film support par pression de celui-ci dans un évidement de corps de carte, avec un poinçon comportant un logement.

16. Procédé selon la revendication 13, **caractérisé en ce qu'**il comprend l'étape consistant à connecter la puce après déformation du film support.

17. Procédé selon la revendication 16, **caractérisé en ce que** le film support est pressé et collé par un poinçon dans un évidement, ou cavité, formé à l'avance dans un corps de carte, la puce étant ensuite connectée, tandis que le film est fixé dans l'évidement.

18. Procédé selon la revendication 16, **caractérisé en ce que**, pour déformer le film, on place celui-ci dans une empreinte d'un moule approprié, on le plaque contre une paroi interne et, après introduction de la matière dans l'empreinte, le film support est déformé par la pression de la matière contre un poinçon (8) ayant une forme complémentaire de celle d'un évidement à former et/ou par le déplacement du poinçon.

## Claims

1. A method for manufacturing a storage support of a flush contacts and/or contactless smart card type, comprising a micromodule including a support film (1) bearing a metallization grid (7), and an integrated circuit chip (9) placed in a transfer zone and connected to the said metallization grid (7), the said method being **characterized in that** it includes the following steps, in an unspecified order:
- preparing a metallization grid (7) on the support film (1) of the micromodule, and
- deforming the support film (1) so that the transfer area is at a lower level compared to the plane of the metallization grid.

2. A method according to claim 1, **characterized in that** it further comprises the subsequent steps of making the process smart cards on reels and/or in line

3. A method according to claim 1, **characterized in that** the metallization grid is obtained by a non-electrolytic method.

4. A method according to claim 3, **characterized in that** it includes the deposition of a metallization grid initiator by an additive method, in the form of a deposit of at least one metallization primer according to predefined patterns corresponding to the surfaces of the said metallization grid, by screen printing, pad printing, offset, ink jet, flexography, plotter or other similar techniques, and non-electrolytic fixing of at least one suitable metal, such as, Cu, Ni and/or Au, catalyzed by the said primer on the areas where it is present.

5. A method according to claim 4, **characterized in that** the metallization primer is selected among the palladium-based catalyst materials, used for the metallization of polymeric substrates.

6. A method according to claim 4, **characterized in that** the metallization primer mainly consists of a film forming agent such as polyurethane, an additive that confers a suitable surface activity, such as a polyester, a polyamide and/or a polyoxazolidone, an ionic and/or colloidal noble metal, or a covalent or complex compound thereof with some organic ligands, in particular a complex or an inorganic salt of Cu, Au, Ag, Pt, Pd or Ru, some organic and/or inorganic fillers and an organic solvent.

7. A method according to claim 4, **characterized in that** it includes the activation of the said primer, particularly by exposure to UV radiation, as well as drying.

8. A method according to claim 4, **characterized in that** it includes the impregnation of the strip formed support immediately or subsequently in a bath (6) of a salt of the metal chosen for the metallization, for example, Cu, Ni and/or Au, in a continuous, sequential or discontinuous manner.

9. A method according to claim 4, **characterized in that** it further includes a subsequent step of electrolytic deposition of an additional layer of metal, such as Cu, Ni, Ag or Pd, on the same areas (7) of the support film as those having received the aforementioned metallization.

10. A method according to claim 3, **characterized in that** it includes the non-electrolytic deposition of at least one suitable metal such as, for example Cu, and the carrying out of the said metallization according to predefined patterns, by a subtractive method based on an image corresponding to the metallization grid, particularly by photolithography.

11. A method according to claim 3, **characterized in that** a thin layer of at least a metal such as Cu, Ni or Au is first applied onto the polymeric substrate to be treated, composed of the aforementioned dielectric support film, preferably by a vacuum deposition method.

12. A method according to one of claims 1 or 2, **characterized in that** a metal grid, mechanically cut-to-size on the support film is rolled.

13. A method according to claim 10, **characterized in that** photolithography proper includes the steps of:
- depositing a layer of photosensitive resin on the aforementioned metal,
- exposure through a mask or a film,
- development of the resin,
- etching the metal in the areas not protected by the resin, and
- removing the photosensitive resin.

14. A method according to claim 10, **characterized in that** either before or after completion of photolithography, an electrolytic deposition is made of a metal coating, in particular a coating with Ni+AU, Ni+Pd and/or Ni+Pd+flash Au, where " flash Au " means a thin deposit of Au.

15. A method according to any of claims 1 to 14, **characterized in that** it further comprises the following steps, consisting in: mounting and connecting the chip prior to deforming the dielectric support film, then deforming the support film by pressing it into a recess of the card body, using a punch containing a recess.

16. A method according to claim 13, **characterized in that** it comprises the step consisting in connecting the chip after deforming the support film.

17. A method according to claim 13, **characterized in that** the support film is pressed and glued by a punch into a recess or cavity, formed in advance in a card body, the chip then being connected, while the film is clamped in the recess.

18. A method according to claim 16, **characterized in that**, to deform the film, the latter is placed in a mould cavity of a suitable mould, pressed against an internal wall and, after introduction of the material into the mould cavity, the support film is deformed by the pressure of the material against a punch (8) having a shape complementary to that of the recess to be formed and/or by displacement of the punch.

## Patentansprüche

1. Herstellungsverfahren eines Speicherträgers vom Typ Chipkarte mit versenkten Kontakten und / oder ohne Kontakt, umfassend ein Mikromodul mit einem ein Metallisierungsgitter (7) tragenden Trägerfilm (1) und einem in einem Übertragungsbereich untergebrachten und mit dem besagten Metallisierungsgitter (7) verbundenen, integrierten Schaltkreis-Chip (9), wobei das besagte Verfahren **dadurch gekennzeichnet ist, dass** es in beliebiger Reihenfolge Stufen beinhaltet, bestehend aus:
- der Realisierung eines Metallisierungsgitters (7) auf dem Trägerfilm (1) des Mikromoduls und
- der Verformung des Trägerfilms (1) derart, dass wenigstens der besagte Übertragbereich sich im Verhältnis zur Ebene des besagten Metallisierungsgitters auf einem unteren Niveau befindet.

2. Verfahren gemäß Anspruch 1, **dadurch gekennzeichnet, dass** es darüber hinaus die späteren Anfertigungsstufen der Chipkarten auf einer Spule und / oder in der Linie umfasst.

3. Verfahren gemäß Anspruch 1, **dadurch gekennzeichnet, dass** man das Metallisierungsgitter durch ein nicht elektrolytisches Verfahren realisiert.

4. Verfahren gemäß Anspruch 3, **dadurch gekennzeichnet, dass** es das Aufbringen eines Katalysators des Metallisierungsgitters durch eine additive Methode in Form eines Auftragens von wenigstens einem Ausgangspunkt der Metallisierung gemäß den Flächen des besagten Metallisierungsgitters entsprechenden vordefinierten Motive durch Serigraphie, Stempeldruck, Offset, Tintenstrahldruck, Flexodruck, Absteckmittel oder jede ähnliche Technik und anschließend die nicht elektrolytische Fixierung wenigstens eines geeigneten Metalls, wie zum Beispiel Cu, Ni und / oder AU umfasst, die durch den besagten Ausgangspunkt auf den Bereichen, auf denen er vorhanden ist, katalysiert wird.

5. Verfahren gemäß Anspruch 4, **dadurch gekennzeichnet, dass** der Ausgangspunkt der Metallisierung aus für die Metallisierung polymerer Substrate eingesetztem katalytischem Material auf Palladiumbasis ausgewählt wird.

6. Verfahren gemäß Anspruch 4, **dadurch gekennzeichnet, dass** der Ausgangspunkt der Metallisierung im Wesentlichen aus einem filmbildenden Mittel besteht, wie zum Beispiel Polyurethan, einem eine geeignete Spannungsaktivität verleihenden Zusatz, wie zum Beispiel Polyester, ein Polyamid und / oder ein Polyoxazolidon, ein ionisches und / oder kolloidales Edelmetall oder eine kovalente Komponente oder Komplex desselben mit organischen Liganden, insbesondere ein Komplex oder ein anorganisches CU-, Au-, Ag-, Pt-, Pd- oder Ru-Salz, organische und / oder anorganische Chargen und ein organisches Lösungsmittel.

7. Verfahren gemäß Anspruch 4, **dadurch gekennzeichnet, dass** es eine Aktivierung des besagten Ausgangspunkts, insbesondere durch Einwirkung von UV-Strahlen, sowie ein Trocknen beinhaltet.

8. Verfahren gemäß Anspruch 4, **dadurch gekennzeichnet, dass** es die ununterbrochene, sequentielle oder unterbrochene Imprägnierung eines Trägers in Form eines Bandes direkt oder nach einem Bad (6) in einem zur Metallisierung ausgewählten Metallsalz umfasst, zum Beispiel Cu, Ni und / oder Au.

9. Verfahren gemäß Anspruch 4, **dadurch gekennzeichnet, dass** es darüber hinaus eine darauffolgende elektrolytische Auftragstufe einer zusätzlichen Metallschicht, wie zum Beispiel Cu, Ni, Au oder Pd, auf denselben Bereichen (7) des Trägerfilms wie denen umfasst, die die oben genannte Metallisierung aufgenommen haben.

10. Verfahren gemäß Anspruch 3, **dadurch gekennzeichnet**, das es das nicht elektrolytische Auftragen wenigstens eines geeigneten Metalls, wie zum Beispiel Cu, und die Realisierung der Metallisierung gemäß vordefinierter Motive durch eine subtraktive Methode gemäß einem dem besagten Metallisierungsgitter entsprechenden Bild, insbesondere durch Fotolithographie, umfasst.

11. Verfahren gemäß Anspruch 3, **dadurch gekennzeichnet, dass** man zunächst auf dem zu behandelnden, durch den oben genannten dielektrischen Trägerfilm gebildeten polymeren Substrat eine dünne Schicht wenigstens eines Metall, wie zum Beispiel Cu, Ni oder Au, vorzugsweise durch eine Auftragstechnik unter Vakuum, aufträgt.

12. Verfahren gemäß Anspruch 1 oder 2, **dadurch gekennzeichnet, dass** man ein mechanisch ausgeschnittenes Metallgitter auf den Trägerfilm aufwalzt.

13. Verfahren gemäß Anspruch 10, **dadurch gekennzeichnet, dass** die Fotolithographie im eigentlichen Sinne folgende Stufen beinhaltet:
- Aufbringen einer fotosensiblen Harzschicht auf das oben genannte Metall,
- Strahleneinwirkung durch eine Maske oder einen Film,
- Entwicklung des Harzes,
- Gravur des Metalls in den nicht vom Harz geschützten Bereichen, und
- Entfernen des fotosensiblen Harzes.

14. Verfahren gemäß Anspruch 10, **dadurch gekennzeichnet, dass** man darüber hinaus entweder vor oder nach der Umsetzung der Fotolithographie elektrolytisch eine Metallbeschichtung aufbringt, insbesondere eine Beschichtung aus Ni + Au, Ni + Pd und / oder Ni + Pf + Blitz Au, wobei "Blitz Au" ein Depot geringer Stärke des Metalls Au bezeichnet.

15. Verfahren gemäß Anspruch 1 bis 14, **dadurch gekennzeichnet, dass** es darüber hinaus die folgenden Stufen beinhaltet, bestehend aus: Befestigung und Verbindung des Chips vor der Verformung des dielektrischen Trägerfilms, dann die Verformung des Trägerfilms durch Druck desselben in einer Körperaussparung der Karte, wobei ein Stanzer eine Aufnahme umfasst.

16. Verfahren gemäß Anspruch 13, **dadurch gekennzeichnet, dass** es die Stufe beinhaltet, bestehend im Verbinden des Chips nach Verformung des Trägerfilms.

17. Verfahren gemäß Anspruch 16, **dadurch gekennzeichnet, dass** der Trägerfilm durch einen Stanzer in einer zuvor in einem Kartenkörper gebildeten Aussparung oder Aushöhlung gepresst und geklebt wird, wobei der Chip anschließend angeschlossen wird, während der Film in der Aussparung befestigt wird.

18. Verfahren gemäß Anspruch 16, **dadurch gekennzeichnet, dass** man zum Verformen des Films diesen in einen Abdruck einer geeigneten Form platziert, man ihn gegen eine Innenwand drückt und nach dem Einführen des Materials in den Abdruck der Trägerfilm durch Pressen des Materials gegen einen Stanzer (8) in zu der einer zu bildenden Aussparung komplementären Form und / oder durch Verschieben des Stanzers verformt wird.
